# EUROPEAN PATENT APPLICATION

(11) **EP 4 498 311 A1**
(43) Date of publication of application: **29.01.2025**
(21) Application number: 24190494.5
(22) Date of filing: 24.07.2024
(51) Int. Cl.: G06Q 30/04, G06Q 30/0201, G06Q 10/04, G06Q 50/06

(54) **BILLED CONSUMPTION USAGE INTERVAL ESTIMATION**

(30) Priority: 24.07.2023 US 202318225346
(71) Applicant: ITRON, INC., Liberty Lake, WA 99019 (US)
(72) Inventor: HOFFMAN, Elaine J., Liberty Lake, 99019 (US); SANDOVAL, Michael, Liberty Lake, 99019 (US); LENG, Lingling, Liberty Lake, 99019 (US); LEBLANC, Dwayne Allen, Liberty Lake, 99019 (US); SIMONS, Richard, Liberty Lake, 99019 (US)
(74) Representative: Morrall, Jonathan Ian McLachlan

(57) **Abstract**

A utility consumption information system may generate a variety of data that is based on and/or derived from utility consumption or usage associated with a site. In some examples, the utility consumption information system may generate data to be provided or displayed by applying a load profile to utility consumption or usage data obtained at the site over a period of time. The utility consumption information system may generate the load profile based on sample interval data obtained from one or more devices (e.g., utility metering devices) sharing characteristics with the site at which the utility consumption or usage data was obtained.

## Description

### BACKGROUND

Consumption or usage information of a utility service (such as gas, water, electricity, etc.) is valuable not only to utility service providers but also utility service consumers and energy retailers. Utility service providers have utility metering systems that collect utility consumption information for residential and commercial sites accumulated on a monthly basis, bounded in time by the entire billing cycle (usually 28 to 33 days in the United States). Such infrequent feedback from the utility service does not provide adequate information to consumers to modify their behavior in response to costs or for energy retailers to understand their costs.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures indicates similar or identical items.
FIG. 1 illustrates an example environment implementing a utility consumption information system.
FIG. 2 illustrates the example utility consumption information system of FIG. 1 in more detail.
FIG. 3 illustrates an example user interface displaying utility consumption information.
FIGS. 4-7 illustrate example methods to generate utility consumption information.

### DETAILED DESCRIPTION

### Overview

As noted above, utility service consumers are not provided with utility consumption information in a timely manner, and therefore cannot monitor or control utility usage in a knowledgeable and/or intelligent manner. This disclosure describes a utility consumption information system, which generates informative data related to a user's utility consumption over time, enabling the user and/or a utility provider to determine factors that affect the utility usage in a timely and easily understood manner.

In one implementation, the utility consumption information system may generate and store consumption information of a utility service (such as water, gas, electricity, etc.) associated with a site on a regular basis, continuously and/or at a request of a user. The site may include a real estate site such as a residential or commercial site, or a sub portion of a site such as a room, an apartment, a house, an office, a multi-unit building, etc. Additionally or alternatively, in some implementations, the site may be limited to one or more appliances (e.g., a water heater, a furnace, an air conditioning system, etc.), etc. The user may include, for example, a utility service consumer, an authorized agent of an associated utility service provider and/or a maintenance person of the site. The utility consumption information system generates data that enables the utilities and their consumers to see how much, and when a particular utility is consumed. The data generated by the utility consumption information system may be used in calculating and sending customer bills, utility capacity planning, utility rate design, customer engagement (e.g., sharing usage information via a customer portal), load research, submitting settlements to independent system operator (ISO) / regional transmission organization (RTO), calculation of unbilled energy, reducing rates during off-peak periods of the day, and reporting utility reliability metrics (e.g., System Average Interruption Duration Index (SAIDI), System Average Interruption Frequency Index (SAIFI), Customer Average Interruption Duration Index (CAIDI), Customer Average Interruption Frequency Index (CAIFI), Momentary Average Interruption Duration Index (MAIDI), Momentary Average Interruption Frequency Index (MAIFI), etc.) to the Federal Energy Regulatory Commission (FERC).

The utility consumption information system may generate a variety of data that is based on and/or derived from the utility consumption or usage associated with the site. In one implementation, the utility consumption information system may derive data to be provided or displayed by applying a load profile to utility consumption or usage data obtained at the site over a period of time. The utility consumption information system may generate the load profile based on sample interval data obtained from one or more devices (e.g., utility metering device(s)) located at the site and/or at another site within a predefined distance to the site in which the utility consumption information system is monitoring. The utility consumption information system may determine which load profile to apply to billed consumption data of the site for a given period of time based on the site being geographically similar (e.g., within a threshold distance, at a similar latitude, at a similar altitude, within a threshold temperature/humidity, etc.), and/or having similar customer characteristics (e.g., single-family home, small commercial facility, etc.), and/or having similar weather data to the site in which the sample interval data was obtained. Additionally or alternatively, the utility consumption information system may determine which load profile to apply to billed consumption data of the site for a given period of time based on the site being in the same customer class (e.g., residential customer, commercial customer, or industrial customer) as the site in which the sample interval data was obtained.

By way of example and not limitation, the utility consumption information system may receive sample interval data for a period of time from a sample device that is associated with a particular customer class. For example, the sample device may be a utility meter that is in communication with the utility consumption information system and provides the utility consumption information system with consumption data readings on an interval basis (e.g., every hour). In some cases, the utility consumption information system may receive sample data from multiple meters (e.g., 200, 300, 400, etc.) representative of different customer classes and different geographical regions experiencing different types of weather. In some cases, the utility consumption information system may determine weather data indicating the weather that was experienced by the sample meter at the period of time in which the sample data was obtained. In some examples, the weather data may be obtained from a third-party resource.

In some examples, the utility consumption information system may generate a load profile associated with the sample meter and the period of time in which the sample data was obtained. For example, the load profile may indicate a shape formed by the sample data (also referred to as interval data) obtained from the sample device that is determined by one or more statistical models that relate one or more factors, such as weather data, time data (e.g., day or night, weekends, holidays, etc.), and/or customer classification. The shape of the load profile may enable the utility consumption information system to allocate larger portions of a utility bill to a higher frequency interval and smaller portions of a utility bill to a lower frequency interval. The utility consumption information system may generate multiple load profiles representative of different customer classes and different geographical regions experiencing different types of weather such that each region and/or territory in which the utility provides a service may have one or more load profiles associated with customers in that region and/or territory.

In some cases, the utility consumption information system may receive billed consumption data for a utility metering device and apply a load profile to the billed consumption data. In some cases, the load profile may be applied based at least in part on the utility metering device being associated with a particular customer class. For instance, the utility consumption information system may determine that the utility metering device is associated with a residential customer and may determine to apply a load profile to the billed consumption data that is also associated with residential customers (e.g., a load profile generated based on sample data obtained from a sample device also in the residential customer class). In some cases, the load profile may be applied to the billed consumption data based at least in part on weather data associated with the utility metering device during the period in time in which the utility was billed. For example, each load profile may be associated with particular weather data experienced by the sample device from which the load profile was generated. The utility consumption information system may apply load profiles to billed consumption data based on a similarity between the weather data associated with the utility metering device during the period in time in which the utility was billed and the weather data associated with each load profile. In some cases, the load profile may be applied to the billed consumption data based at least in part on the utility meter being within a geographical distance to a particular sample device. For instance, the utility consumption information system may receive sample data (e.g., interval data) from multiple sample devices each of which is located in a geographical area. Other utility metering devices may be located within those geographical areas (e.g., within a 5-mile radius) and the utility consumption information system may determine to apply a load profile to billed consumption data based on the load profile generated for the sample device located in the same geographical area as the utility metering device.

In some cases, the utility consumption information system may utilize a combination of data to determine which load profile to apply to the billed consumption data and to generate interval data associated with the billed consumption data. For example, the utility consumption information system may utilize customer class data (e.g., residential customer, commercial customer, or industrial customer), weather data, and/or geographic data to determine which load profile to apply to the billed consumption data to generate the interval data. In this way, the utility consumption information system may allocate larger portions of a utility bill to a higher frequency interval as opposed to the initially received billed consumption data, which only indicates an overall amount of energy or water consumed and/or billed for a period of time.

In some cases, the utility consumption information system may provide these interval data in a variety of forms including, for example, textual, tabular, graphical and/or animation formats. Examples of the interval data may include, but are not limited to, an absolute and/or relative value of the utility consumption at one point of time or within a time interval, a cumulative value of the utility consumption over a period of time, a peak value of the utility consumption within a time interval, etc. Additionally or alternatively, the interval data may include a rate of change of the utility consumption over a period of time, a trend of the utility consumption over a period of time, a progress of the utility consumption with respect to one or more target, goal or baseline references, etc.

The application describes multiple and varied embodiments and implementations. The following section describes an example environment that is suitable for practicing various implementations. Next, the application describes example systems, devices, and processes for providing utility consumption information.

### Example Environment

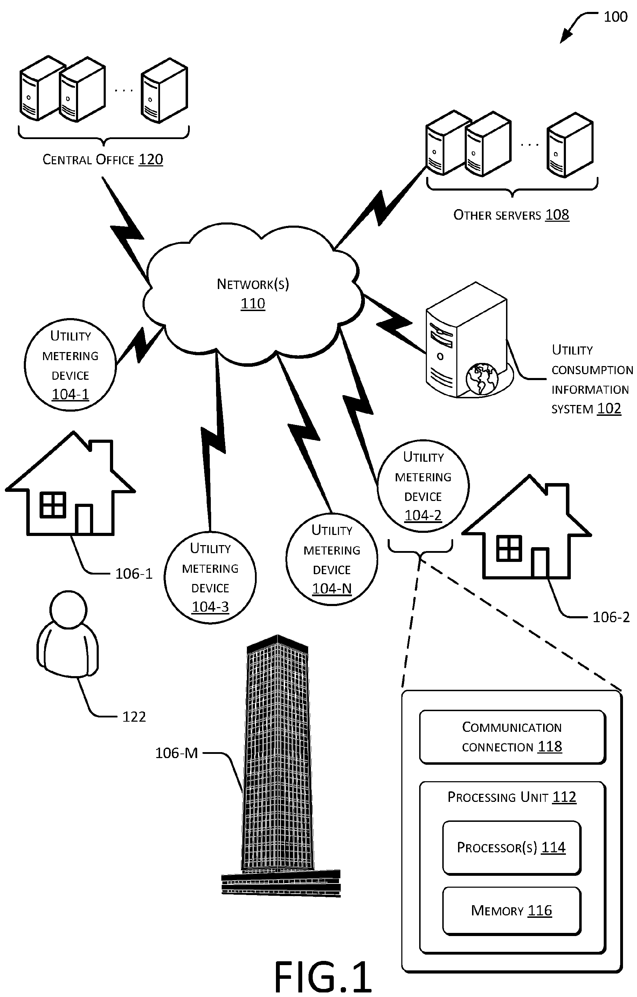

FIG. 1 is a schematic diagram of an example environment 100 implementing a utility consumption information system 102. The environment 100 may further include one or more utility metering devices 104-1, 104-2, 104-3, ... , 104-N (collectively referred to as utility metering devices 104) associated or installed with one or more sites 106-1, 106-2, ..., 106-M (collectively referred to as sites 106). In some implementations, the environment 100 may include one or more servers 108. In this example, the utility consumption information system 102 may communicate with the one or more utility metering devices 104 and/or the one or more servers 108 over a communication network 110.

In FIG. 1, the utility consumption information system 102 is shown to be an individual or separate entity from the utility metering devices 104, the sites 106 and the servers 108. However, in some implementations, the utility consumption information system 102 may be included in a utility metering device 104, a site 106 and/or the one or more servers 108. Furthermore, some or all of the functions of the utility consumption information system 102 may be implemented in the utility metering devices 104, the sites 106 and/or the servers 108.

Additionally or alternatively, the utility consumption information system 102 may be an application or service provided in a computing device and may provide utility consumption data in a display of the computing device. The computing device may be a mainframe computer, a server, a notebook or portable computer, a handheld device, a netbook, an Internet appliance, a tablet or slate computer, a mobile device (e.g., a mobile phone, a personal digital assistant, a smart phone, etc.), a game console, etc., or a combination thereof.

In one implementation, the site of utility consumption may be a real property such as a residential or commercial property, a room, an apartment, a house, an office, a multi-unit building, etc. Additionally or alternatively, the site may be an appliance or other utility-consuming device (e.g., a water heater, a furnace, an air conditioning system, etc.). In some implementations, the site may include one or more residential (or commercial) properties and/or appliances sharing a common utility metering device, such as the utility metering device 104-2.

Furthermore, the communication network 110 may be a wireless or a wired network, or a combination thereof. The network 110 may be a collection of individual networks interconnected with each other and functioning as a single large network (e.g., the Internet or an intranet). Examples of such individual networks include, but are not limited to, telephone networks, cable networks, Local Area Networks (LANs), Wide Area Networks (WANs), and Metropolitan Area Networks (MANs). Further, the individual networks may be wireless or wired networks, or a combination thereof. In some implementations, the communication network 110 may include one or more types of communication channels, such as a power line communication (PLC) channel, a radio frequency (RF) channel, a physical cable channel, etc.

In one implementation, the utility metering devices 104 may be implemented as one of a variety of devices, which may include smart utility meters (e.g., electric, gas, heat, and/or water meters), sensors (e.g., temperature sensors, weather stations, frequency sensors, etc.), control devices, transformers, routers, servers, relays (e.g., cellular relays), switches, valves, or a combination of the foregoing.

Additionally, in some implementations, the utility metering device 104 (as representative by any of the utility metering devices 104 in FIG. 1) may include a processing unit 112. The processing unit 112 may include one or more processor(s) 114 communicatively coupled to memory 116. The memory 116 may be configured to store one or more software and/or firmware components, which are executable on the processor(s) 114 to implement various functions. While the components are described herein as being software and/or firmware stored in memory and executable on a processor, in other implementations, any or all of the components may be implemented in whole or in part by hardware (e.g., as an ASIC, a specialized processing unit, etc.) to execute the described functions.

The memory 116 may comprise computer-readable media and may take the form of volatile memory, such as random access memory (RAM) and/or non-volatile memory, such as read only memory (ROM) or flash RAM. Computer-readable media includes volatile and non-volatile, removable and non-removable media implemented in any method or technology for storage of information such as computer-readable instructions, data structures, program components, or other data for execution by one or more processors of a computing device. Examples of computer-readable media include, but are not limited to, phase change memory (PRAM), static random-access memory (SRAM), dynamic random-access memory (DRAM), other types of random access memory (RAM), read-only memory (ROM), electrically erasable programmable read-only memory (EEPROM), flash memory or other memory technology, compact disk read-only memory (CD-ROM), digital versatile disks (DVD) or other optical storage, magnetic cassettes, magnetic tape, magnetic disk storage or other magnetic storage devices, or any other non-transmission medium that can be used to store information for access by a computing device. As defined herein, computer-readable media does not include communication media, such as modulated data signals and carrier waves.

The utility metering device 104 may include a communication connection 118. The communication connection 118 may include a wireless connection (such as a WiFi connection, a radio frequency (RF) channel connection or a Bluetooth^{®} connection, etc.), a wired connection (such as USB, Ethernet, PLC, or other physical cable connection, etc.), or both wireless and wired connections.

The environment 100 may include a central office 120, which may be part of a utility service provider or company. The central office 120 may include a centralized meter data management system to perform processing, analysis, storage, and/or management of data received from one or more of the utility metering devices 104. For instance, the central office 120 may process, analyze, store, and/or manage data obtained from a smart utility meter, sensor, control device, router, regulator, server, relay, switch, valve, and/or other devices. Additionally or alternatively, the central office 120 may include a network management system (NMS) for maintaining a registry of devices of the AMI network, device configuration settings, version information, and the like. Although the example of FIG. 1 illustrates the central office 120 in a single location, the central office 120 may be distributed amongst multiple locations (e.g., the servers 108) or may be eliminated entirely (e.g., in the case of a highly decentralized distributed computing platform).

A user 122 may be interested in monitoring and/or determining utility consumption or usage associated with a specific site (e.g., the site 106-1), and employ the utility consumption information system 102 to provide utility consumption information of that site.

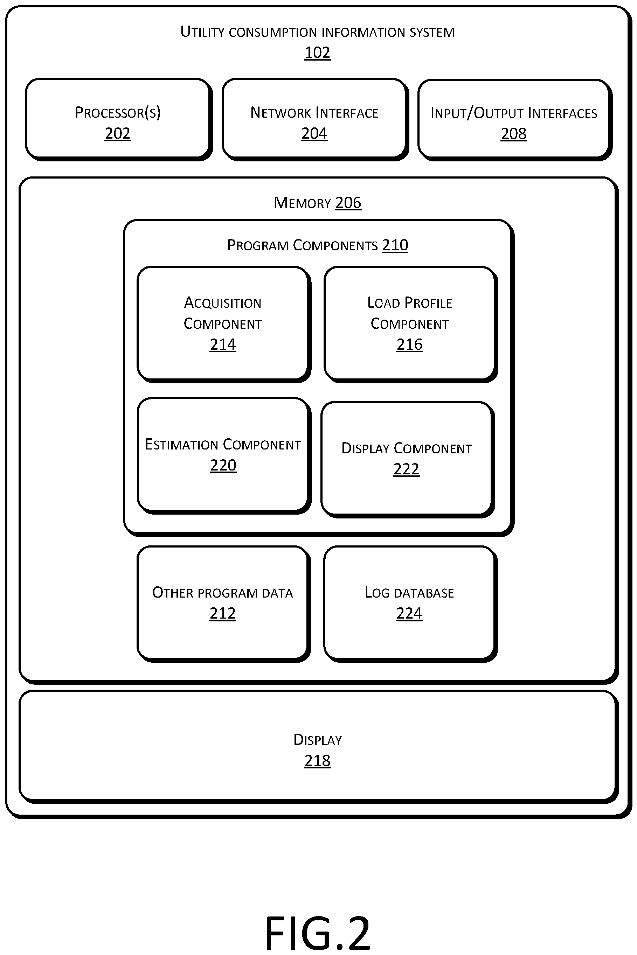

FIG. 2 illustrates the utility consumption information system 102 in more detail. In one implementation, the utility consumption information system 102 may include one or more processors 202, a network interface 204, memory 206, and an input/output interface 208. The processor(s) 202 is configured to execute instructions received from the network interface 204, received from the input/output interface 208, and/or stored in the memory 206. The memory 206 may include computer-readable media.

In one implementation, the utility consumption information system 102 may further include program components 210 and other program data 212. The program components 210 may include an acquisition component 214 that obtains or retrieves utility consumption information from a utility metering device 104 associated with a site 106. Without loss of generality, and in some cases, the acquisition component 214 may obtain utility information associated with the site 106-1 from the utility metering device 104-1. The obtained or retrieved utility information may include raw data (such as consumption usage reading of a utility service) measured and/or output by the utility metering device 104-1 for the site 106-1. In some implementations, the obtained or retrieved utility information may include identification information (such as a device identifier) of the utility metering device 104-1 and/or identification information (such as a consumer identifier, an address, etc.) of the site 106-1. In some implementations, the obtained or retrieved utility information may include billed consumption data indicating an amount of utility that was billed over a particular period of time.

In some cases, the acquisition component 214 may obtain or retrieve this utility consumption information from the central office 120 in cases where the acquisition component 214 is unable to obtain the utility consumption information and/or interval data directly from the utility metering device 104-1. For example, the utility metering device 104-1 may be an older model that does not collect such information. Additionally or alternatively, the utility metering device 104-1 may not have a most current software update required to collect and/or transmit such information. Additionally or alternatively, in the case of industrial customers and/or commercial customers, there may not be a specific utility metering device to obtain consumption information and/or interval data because the utility consumption is widespread across a large geographical area (e.g., via traffic lights, street lights, etc.). The acquisition component 214 may obtain or retrieve the utility consumption information from the central office 120 associated with the utility metering device 104-1 associated with the site 106-1 in response to receiving a request from a data engineer associated with the central office 120 or the user 122. Additionally or alternatively, the acquisition component 214 may obtain or retrieve the utility consumption information associated with the site 106-1 from an associated utility service provider. The utility service provider may provide utility consumption information associated with a plurality of sites 106 through its server (e.g., the servers 108 or the central office 120) or website (which may be hosted in the server 108, for example). The utility consumption information system 102 (or the acquisition component 214) may be allowed to download the utility consumption information associated with the site at issue (i.e., the site 106-1 in this example) from the server 108 or a website of the utility service provider after the utility service provider receives and verifies authentication or identification information sent from the utility consumption information system 102. In one implementation, the authentication or identification information may include, for example, a username and a password set up for that site, a pass code or encryption/decryption key set up between the utility consumption information system 102 and the server 108 or the website of the utility service provider, etc.

In some cases, the acquisition component 214 may receive sample interval data for a period of time from a sample device that is associated with a particular customer class. For example, the sample device may be a utility meter that is in communication with the acquisition component 214 and provides the acquisition component 214 with consumption data readings on an interval basis (e.g., every hour). In some cases, the acquisition component 214 may receive sample data from multiple meters (e.g., 200, 300, 400, etc.) representative of different customer classes and different geographical regions experiencing different types of weather. In some cases, the acquisition component 214 may determine weather data indicating the weather that was experienced by the sample meter at the period of time in which the sample data was obtained. In some examples, the weather data may be obtained from a third-party resource.

Regardless of how the utility consumption information associated with the site is obtained, a load profile component 216 of the utility consumption information system 102 may process the obtained utility consumption information associated with the site 106-1 after obtaining the utility consumption information. For example, the load profile component 216 may generate a load profile associated with a sample meter (e.g., utility metering device 104-2) and the period of time in which the sample data was obtained. For example, the load profile may indicate a shape formed by the sample data (also referred to as interval data) obtained from the sample device that is determined by one or more statistical models that relate one or more factors, such as weather data, time data (e.g., day or night, weekends, holidays, etc.), and/or customer classification. The shape of the load profile may enable the load profile component 216 to allocate larger portions of a utility bill to a higher frequency interval and smaller portions of a utility bill to a lower frequency interval. The load profile component 216 may generate multiple load profiles representative of different customer classes and different geographical regions experiencing different types of weather such that each region and/or territory in which the utility provides a service may have one or more load profiles associated with customers in that region and/or territory.

The load profile component 216 may compute statistical data based on or derived from the obtained utility consumption information. The statistical data may include an absolute and/or relative value of the utility consumption at one point of time or within a time interval, a cumulative value of the utility consumption over a period of time, a peak value of the utility consumption within a time interval, etc. Additionally or alternatively, the statistical data may include a rate of change of the utility consumption over a period of time, a trend of the utility consumption over a period of time, a progress associated with the utility consumption with respect to one or more target or baseline references, etc. The load profile component 216 may obtain these statistical data based on an application of a rolling or sliding window. The load profile component 216 may compute one or more of statistical data and references before or upon receipt of the utility consumption information. The load profile component 216 may compute one or more of the statistical data and references in real time upon receiving a request from a user, such as the user 122.

An estimation component 220 may be used to apply one or more load profiles to received billed consumption data in order to estimate interval data associated with the billed consumption data. For example, the estimation component 220 may receive billed consumption data (e.g., via the acquisition component 214) for a utility metering device and apply a load profile to the billed consumption data. In some cases, the load profile may be applied based at least in part on the utility metering device being associated with a particular customer class. For instance, the estimation component 220 may determine that the utility metering device 104-1 is associated with a residential customer and may determine to apply a load profile to the billed consumption data that is also associated with residential customers (e.g., a load profile generated based on sample data obtained from a sample device (e.g., utility metering device 104-2) also in the residential customer class). In some cases, the load profile may be applied to the billed consumption data based at least in part on weather data associated with the utility metering device 104-1 during the period in time in which the utility was billed. For example, each load profile may be associated with particular weather data experienced by the sample device from which the load profile was generated. The estimation component 220 may apply load profiles to billed consumption data based on a similarity between the weather data associated with the utility metering device 104-1 during the period in time in which the utility was billed and the weather data associated with each load profile. In some cases, the load profile may be applied to the billed consumption data based at least in part on the utility metering device 104-1 being within a geographical distance to a particular sample device (e.g., utility metering device 104-2). For instance, the utility consumption information system may receive sample data (e.g., interval data) from multiple sample devices each of which is located in a geographical area. Other utility metering devices may be located within those geographical areas (e.g., within a 5-mile radius) and the estimation component 220 may determine to apply a load profile to billed consumption data based on the load profile generated for the sample device located in the same geographical area as the utility metering device.

In some cases, the estimation component 220 may utilize a combination of data to determine which load profile to apply to the billed consumption data and to generate interval data associated with the billed consumption data. For example, the estimation component 220 may utilize customer class data (e.g., residential customer, commercial customer, or industrial customer), weather data, and/or geographic data to determine which load profile to apply to the billed consumption data to generate the interval data. In this way, the estimation component 220 may allocate larger portions of a utility bill to a higher frequency interval, as opposed to the initially received billed consumption data, which only indicates an overall amount of utility used and/or billed for a period of time.

The display component 222 may be used to provide these interval data in a variety of forms (e.g., via display 218) including, for example, textual, tabular, graphical and/or animation formats. Examples of the interval data may include, but are not limited to, an absolute and/or relative value of the utility consumption at one point of time or within a time interval, a cumulative value of the utility consumption over a period of time, a peak value of the utility consumption within a time interval, etc. Additionally or alternatively, the interval data may include a rate of change of the utility consumption over a period of time, a trend of the utility consumption over a period of time, a progress of the utility consumption with respect to one or more target, goal or baseline references, etc.

The utility consumption information system 102 may include a log database 224. The log database 224 may store the utility consumption data of the site 106. The log database 224 may also store data representing one or more billing cycles. The log database 224 may store predefined settings of the utility consumption information system 102 and/or instructions received from the user 122.

### Example User Interface

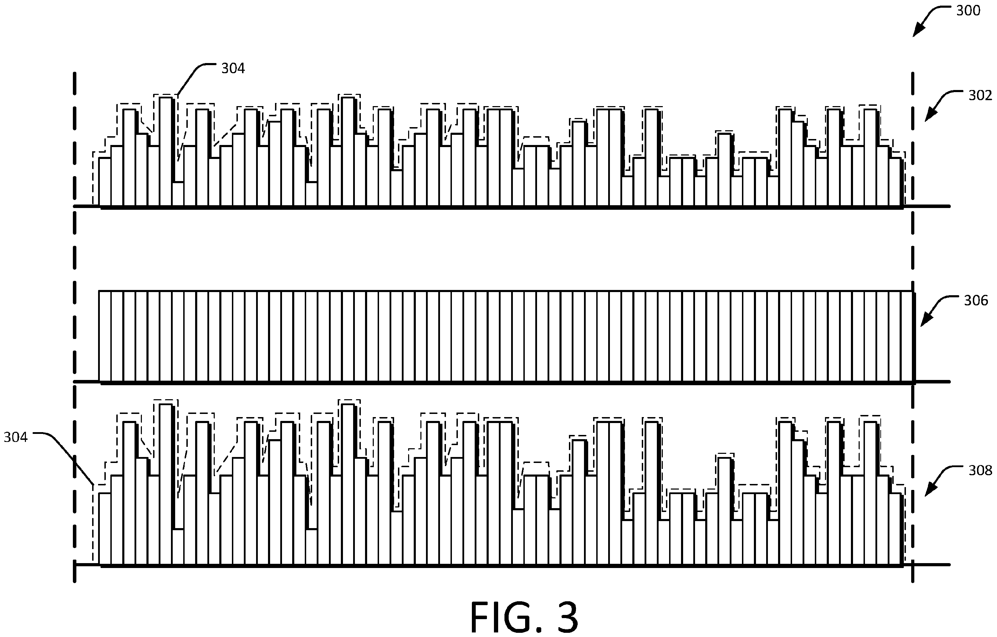

FIG. 3 illustrates an example user interface displaying statistical data and references of the utility consumption information that are of interest to a user, such as the user 122. The example user interface may display aspects of estimated interval data associated with billed consumption data. The example user interface is representative of user interfaces usable with a utility consumption system and/or estimated billing techniques discussed herein.

In the example shown in FIG 3., utility consumption information of a site in which a sample device (e.g., utility metering device 104-2) located at a site (e.g., site 106-2) is shown with utility consumption information displayed as interval data (e.g., displayed as utility consumed per hour, per second, per minute, etc.). For example, the user interface 300 may include a graphical chart 302 associated with the site 106-2 in which a sample device, such as the utility metering device 104-2, may provide the utility consumption information system with consumption data readings on an interval basis (e.g., every hour). In some cases, the utility consumption information system may receive sample data from multiple meters (e.g., 200, 300, 400, etc.) representative of different customer classes and different geographical regions experiencing different types of weather. In some examples, the utility consumption information system may generate a load profile 304 associated with the sample meter and the period of time in which the sample data was obtained. For example, the load profile 304 may indicate a shape formed by the sample data (also referred to as interval data) obtained from the sample device that is determined by one or more statistical models that relate one or more factors, such as weather data, time data (e.g., day or night, weekends, holidays, etc.), and/or customer classification. The shape of the load profile may enable the utility consumption information system to allocate larger portions of a utility bill to a higher frequency interval and smaller portions of a utility bill to a lower frequency interval.

In some implementations, a graphical chart 306 may represent billed consumption data obtained for a site, such as site 106-1, in which interval data is not available due to a lack of capability of the utility metering device at the site (e.g., utility metering device 104-1)and/or a lack of a meter altogether at the site, such as the case with some commercial customers and/or industrial customers. As shown in the graphical chart 306, the billed consumption data may be displayed evenly over each interval such that only the total amount of utility billed for the given period is known, as opposed to utility usage per each interval.

In some examples, a graphical chart 308 may represent billed consumption data obtained for a site, such as site 106-1, in which the load profile 304 is applied to the billed consumption data from the graphical chart 306. In some cases, the load profile 304 may be applied based at least in part on the utility metering device being associated with a particular customer class. For instance, the utility consumption information system may determine that the utility metering device associated with the billed consumption data illustrated in graphical chart 306 is associated with a residential customer and may determine to apply the load profile 304 to the billed consumption data that is also associated with residential customers (e.g., the load profile 304 generated based on the sample data obtained from the sample device also in the residential customer class illustrated in graphical chart 302). In some cases, the load profile 304 may be applied to the billed consumption data based at least in part on weather data associated with the utility metering device associated with the graphical chart 306 during the period in time in which the utility was billed. For example, each load profile may be associated with particular weather data experienced by the sample device associated with the graphical chart 302 from which the load profile 304 was generated. The utility consumption information system may apply load profiles to billed consumption data based on a similarity between the weather data associated with the utility metering device during the period in time in which the utility was billed and the weather data associated with each load profile. In some cases, the load profile 304 may be applied to the billed consumption data based at least in part on the utility meter being within a geographical distance to a particular sample device. For instance, the utility consumption information system may receive sample data (e.g., interval data) from the utility metering device 104-2 which is located at the site 106-2. Utility metering device 104-1 may be located at site 106-1, which may be located within a same and/or similar geographical area (e.g., within a 5-mile radius) as the site 106-2 and the utility consumption information system may determine to apply the load profile 304 to the billed consumption data from graphical chart 306 based on the load profile 304 generated for the sample device located in the site 106-2.

In some cases, the utility consumption information system may utilize a combination of data to determine which load profile to apply to the billed consumption data and to generate interval data associated with the billed consumption data. For example, the utility consumption information system may utilize customer class data (e.g., residential customer, commercial customer, or industrial customer), weather data, and/or geographic data to determine which load profile to apply to the billed consumption data to generate the interval data. In this way, the utility consumption information system may allocate larger portions of a utility bill to a higher frequency interval and smaller portions of a utility bill to a lower frequency interval, as opposed to the initially received billed consumption data, which only indicates an overall amount of utility used and/or billed for a period of time.

### Exemplary Flowchart

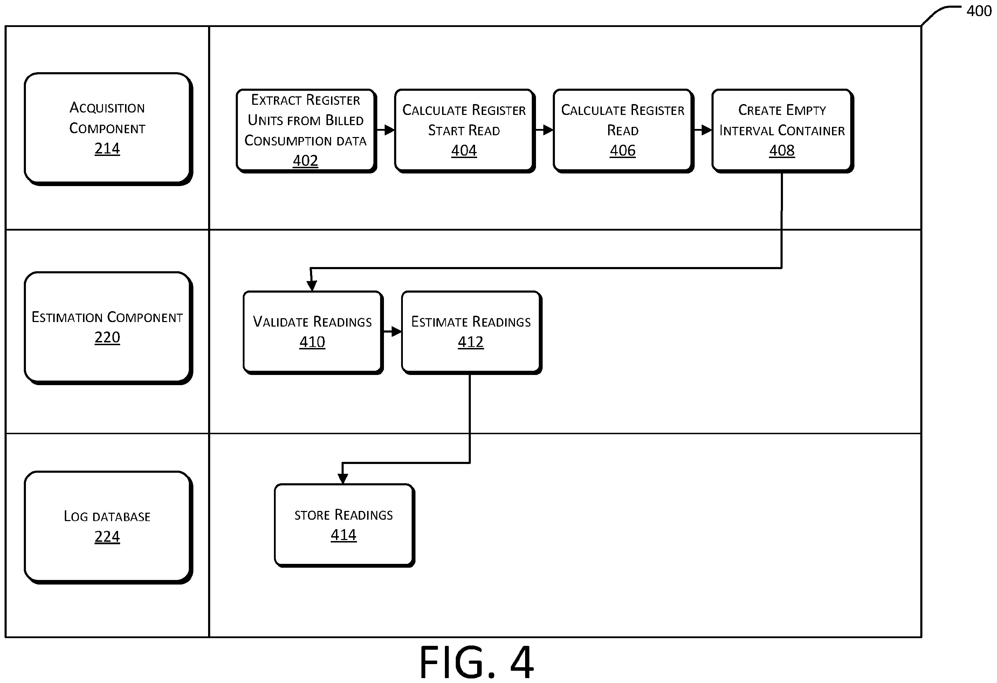

FIG. 4 illustrates a process for estimating interval readings for billed consumption data. The processes described herein are illustrated as collections of blocks in logical flow diagrams, which represent a sequence of operations, some or all of which may be implemented in hardware, software or a combination thereof. In the context of software, the blocks may represent computer-executable instructions stored on one or more computer-readable media that, when executed by one or more processors, program the processors to perform the recited operations. Generally, computer-executable instructions include routines, programs, objects, components, data structures and the like that perform particular functions or implement particular data types. The order in which the blocks are described should not be construed as a limitation, unless specifically noted. Any number of the described blocks may be combined in any order and/or in parallel to implement the process, or alternative processes, and not all of the blocks need to be executed. For discussion purposes, the processes are described with reference to the environments, architectures and systems described in the examples herein, such as, for example those described with respect to FIG. 4, although the processes may be implemented in a wide variety of other environments, architectures and systems.

FIG. 4 illustrates a flow diagram of an example process 400 for estimating interval readings for billed consumption data in accordance with the utility consumption information system 102. The order in which the operations or steps are described is not intended to be construed as a limitation, and any number of the described operations may be combined in any order and/or in parallel to implement process 400. The operations described with respect to the process 400 are described as being performed by the utility consumption information system 102, which includes but is not limited to the acquisition component 214, the estimation component 220, and the log database 224. However, it should be understood that some or all of these operations may be performed by some or all of components, devices, and/or systems described herein.

At block 402, the process 400 may include the acquisition component 214 extracting register units from billed consumption data. For example, the acquisition component 214 may obtain or retrieve utility consumption information from a utility metering device 104 associated with a site 106. Without loss of generality, the acquisition component 214 is described to obtain utility information associated with the site 106-1 from the utility metering device 104-1 hereinafter. The obtained or retrieved utility information may include raw data (such as consumption usage reading of a utility service) measured and/or output by the utility metering device 104-1 for the site 106-1. In some implementations, the obtained or retrieved utility information may include identification information (such as a device identifier) of the utility metering device 104-1 and/or identification information (such as a consumer identifier, an address, etc.) of the site 106-1. In some implementations, the obtained or retrieved utility information may include billed consumption data indicating an amount of utility that was billed over a particular period of time. In some cases, the acquisition component 214 may obtain or retrieve this utility consumption information from the central office 120 in cases where the acquisition component 214 is unable to obtain the utility consumption information and/or interval data directly from the utility metering device 104-1. For example, the utility metering device 104-1 may be an older model that does not collect such information. Additionally or alternatively, the utility metering device 104-1 may not have a most current software update required to collect and/or transmit such information. Additionally or alternatively, in the case of industrial customers and/or commercial customers, there may not be a specific utility metering device to obtain consumption information and/or interval data because the utility consumption is widespread across a large geographical area (e.g., via traffic lights, street lights, etc.). In some cases, the acquisition component 214 may obtain or retrieve the utility consumption information from the central office 120 associated with the utility metering device 104-1 associated with the site 106-1 in response to receiving a request from a data engineer associated with the central office 120 or the user 122. Additionally or alternatively, the acquisition component 214 may obtain or retrieve the utility consumption information associated with the site 106-1 from an associated utility service provider. The utility service provider may provide utility consumption information associated with a plurality of sites 106 through its server (e.g., the servers 108 or the central office 120) or website (which may be hosted in the server 108, for example). The utility consumption information system 102 (or the acquisition component 214) may be allowed to download the utility consumption information associated with the site at issue (i.e., the site 106-1 in this example) from the server 108 or a website of the utility service provider after the utility service provider receives and verifies authentication or identification information sent from the utility consumption information system 102. In one implementation, the authentication or identification information may include, for example, a username and a password set up for that site, a pass code or encryption/decryption key set up between the utility consumption information system 102 and the server 108 or the website of the utility service provider, etc.

In some cases, the billed consumption data (e.g., the utility consumption information) obtained by the acquisition component 214 may be in the form of raw data without any indication of interval usage. The acquisition component 214 may extract register units from the billed consumption data that can be used to eventually calculate a register read. For example, in some cases, the billed consumption data may indicate a running total of utility consumed at a site. That is, many utility metering devices do not simply measure a specific amount of utility consumed for a given period of time, but rather, keep a running total of the amount of utility consumed at the site since the utility metering device was last interrogated. The acquisition component 214 may obtain this running total of the amount of utility consumed at the site and extract register units in order to determine a start value of utility consumption included in the billed consumption data and an end value of utility consumption included in the billed consumption data.

At block 404, the process 400 may include the acquisition component 214 calculating a register start read. For example, the acquisition component 214 may obtain the running total of the amount of utility consumed at the site and extract register units in order to determine a start value of utility consumption included in the billed consumption data and an end value of utility consumption included in the billed consumption data. In some cases, the start value may correspond to a starting date associated with a beginning of a time period (e.g., bill cycle) and the end value may correspond to an end date associated with an end of the time period (e.g., bill cycle).

At block 406, the process 400 may include the acquisition component 214 calculating a register read. For example, the acquisition component 214 may calculate a difference between the start value of utility consumption included in the billed consumption data corresponding to the starting date and the end value of utility consumption included in the billed consumption data corresponding to the end date. The resulting value, the register read, may indicate a total value of utility consumption consumed at the particular site for the given time period.

At block 408, the process 400 may include the acquisition component 214 creating an empty interval container. For example, the register read may be stored in an empty interval container (e.g., database) that evenly distributes values of the register read among a number of intervals. In some cases, the interval container may include 24 intervals to represent 24 hours in a day and the values in the register read may be evenly distributed among the 24 intervals.

At block 410, the process 400 may include the estimation component 220 validating the readings. For example, the estimation component 220 may include one or more algorithms configured to detect if there is an error in the data set stored in the interval container. Examples of errors that may be detected include values above or below a particular maximum threshold value (e.g., a residential utility metering device value should not be above 2,000 kWh) and/or a minimum threshold value (e.g., a residential utility metering device value should not be below 100 kWh). In some cases, these thresholds and/or the types of errors may be configurable by the utility service. In some cases, if an error is detected, the estimation component 220 may flag the data set and second an indication of the error to the utility service.

At block 412, the process 400 may include the estimation component 220 estimating the readings. For example, estimation component 220 may be used to apply one or more load profiles to received billed consumption data in order to estimate interval data associated with the billed consumption data. For example, the estimation component 220 may receive billed consumption data (e.g., via the acquisition component 214) for a utility metering device and apply a load profile to the billed consumption data. In some cases, the load profile may be applied based at least in part on the utility metering device being associated with a particular customer class. For instance, the estimation component 220 may determine that the utility metering device 104-1 is associated with a residential customer and may determine to apply a load profile to the billed consumption data that is also associated with residential customers (e.g., a load profile generated based on sample data obtained from a sample device (e.g., utility metering device 104-2) also in the residential customer class). In some cases, the load profile may be applied to the billed consumption data based at least in part on weather data associated with the utility metering device 104-1 during the period in time in which the utility was billed. For example, each load profile may be associated with particular weather data experienced by the sample device from which the load profile was generated. The estimation component 220 may apply load profiles to billed consumption data based on a similarity between the weather data associated with the utility metering device 104-1 during the period in time in which the utility was billed and the weather data associated with each load profile. In some cases, the load profile may be applied to the billed consumption data based at least in part on the utility metering device 104-1 being within a geographical distance to a particular sample device (e.g., utility metering device 104-2). For instance, the utility consumption information system may receive sample data (e.g., interval data) from multiple sample devices each of which is located in a geographical area. Other utility metering devices may be located within those geographical areas (e.g., within a 5-mile radius) and the estimation component 220 may determine to apply a load profile to billed consumption data based on the load profile generated for the sample device located in the same geographical area as the utility metering device.

In some cases, the estimation component 220 may utilize a combination of data to determine which load profile to apply to the billed consumption data and to generate interval data associated with the billed consumption data. For example, the estimation component 220 may utilize customer class data (e.g., residential customer, commercial customer, or industrial customer), weather data, and/or geographic data to determine which load profile to apply to the billed consumption data to generate the interval data. In this way, the estimation component 220 may allocate larger portions of a utility bill to a higher frequency interval and smaller portions of a utility bill to a lower frequency interval, as opposed to the initially received billed consumption data, which only indicates an overall amount of utility used and/or billed for a period of time.

At block 414, the process 400 may include the log database 224 storing the readings. For example, the utility consumption information system 102 may include a log database 224. The log database 224 may store the utility consumption data of the site 106. The log database 224 may also store data representing one or more billing cycles. The log database 224 may store predefined settings of the utility consumption information system 102 and/or instructions received from the user 122.

### Exemplary Methods

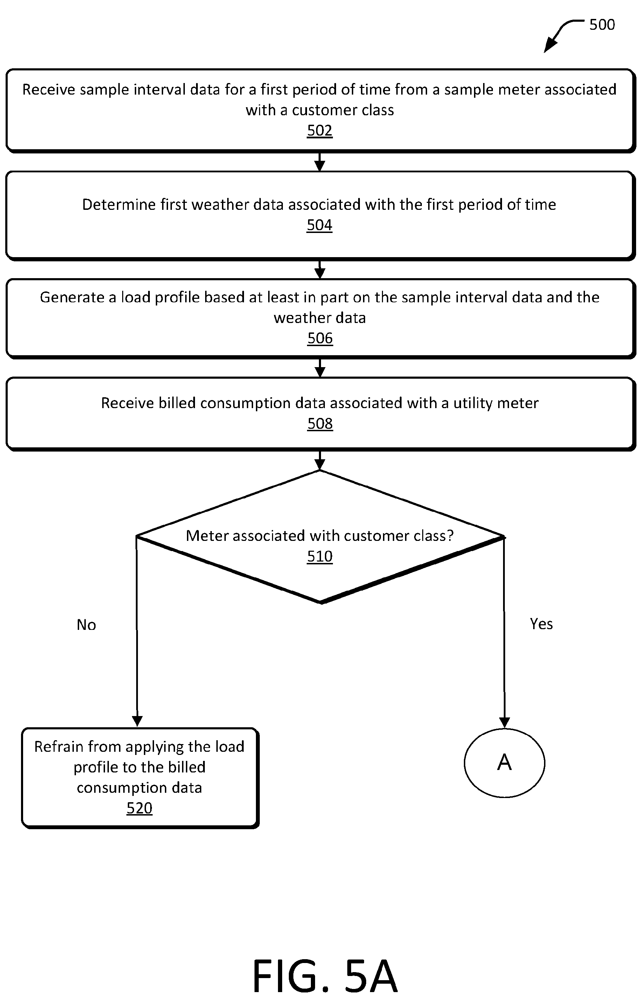

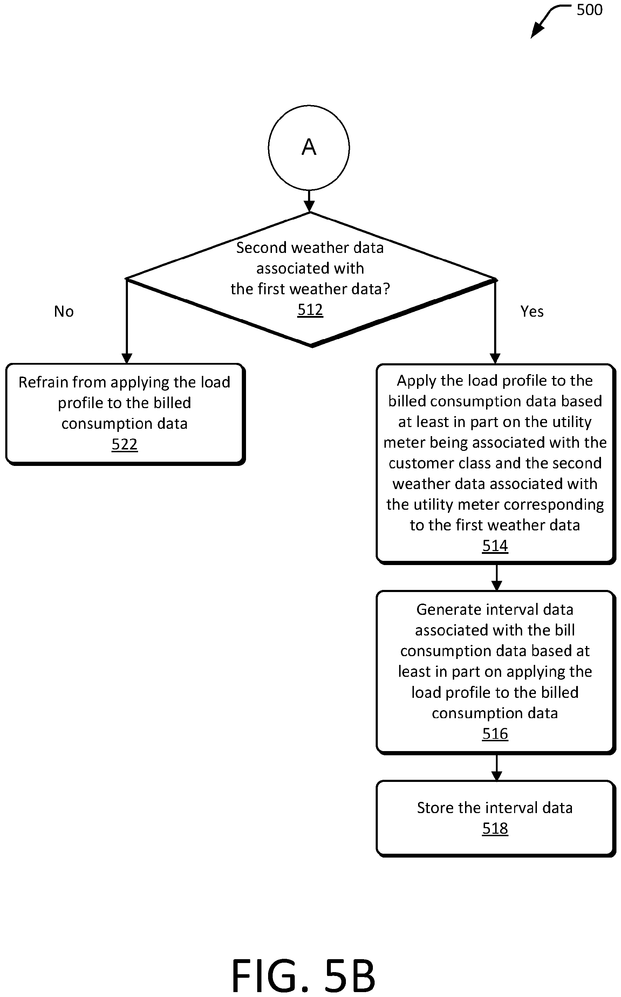

FIGS. 5-7 illustrate processes for estimating interval data for billed utility consumption data. The processes described herein are illustrated as collections of blocks in logical flow diagrams, which represent a sequence of operations, some or all of which may be implemented in hardware, software or a combination thereof. In the context of software, the blocks may represent computer-executable instructions stored on one or more computer-readable media that, when executed by one or more processors, program the processors to perform the recited operations. Generally, computer-executable instructions include routines, programs, objects, components, data structures and the like that perform particular functions or implement particular data types. The order in which the blocks are described should not be construed as a limitation, unless specifically noted. Any number of the described blocks may be combined in any order and/or in parallel to implement the process, or alternative processes, and not all of the blocks need be executed. For discussion purposes, the processes are described with reference to the environments, architectures and systems described in the examples herein, such as, for example those described with respect to FIGS. 1-4, although the processes may be implemented in a wide variety of other environments, architectures and systems.

FIGS. 5A and 5B illustrate a flow diagram of an example process 500 for estimating interval data for billed utility consumption data. The order in which the operations or steps are described is not intended to be construed as a limitation, and any number of the described operations may be combined in any order and/or in parallel to implement process 500. The operations described with respect to the process 500 are described as being performed by the utility consumption information system. However, it should be understood that some or all of these operations may be performed by some or all of components, devices, and/or systems described herein.

At block 502, the process 500 may include receiving sample interval data for a first period of time from a sample meter associated with a customer class. For example, the acquisition component 214 may receive sample interval data for a period of time from a sample device that is associated with a particular customer class. For example, the sample device may be a utility meter that is in communication with the acquisition component 214 and provides the acquisition component 214 with consumption data readings on an interval basis (e.g., every hour). In some cases, the acquisition component 214 may receive sample data from multiple meters (e.g., 200, 300, 400, etc.) representative of different customer classes and different geographical regions experiencing different types of weather.

At block 504, the process 500 may include determining first weather data associated with the first period of time. For example, the acquisition component 214 may determine weather data indicating the weather that was experienced by the sample meter at the period of time in which the sample data was obtained. In some examples, the weather data may be obtained from a third-party resource.

At block 506, the process 500 may include generating a load profile based at least in part on the sample interval data and the weather data. For example, the load profile component 216 may generate a load profile associated with a sample meter (e.g., utility metering device 104-2) and the period of time in which the sample data was obtained. For example, the load profile may indicate a shape formed by the sample data (also referred to as interval data) obtained from the sample device that is determined by one or more statistical models that relate one or more factors, such as weather data, time data (e.g., day or night, weekends, holidays, etc.), and/or customer classification. The shape of the load profile may enable the load profile component 216 to allocate larger portions of a utility bill to a higher frequency interval and smaller portions of a utility bill to a lower frequency interval.

At block 508, the process 500 may include receiving billed consumption data associated with a utility meter. For example, the acquisition component 214 may, in some cases, obtain utility information associated with the site 106-1 from the utility metering device 104-1. The obtained or retrieved utility information may include raw data (such as consumption usage reading of a utility service) measured and/or output by the utility metering device 104-1 for the site 106-1. In some implementations, the obtained or retrieved utility information may include identification information (such as a device identifier) of the utility metering device 104-1 and/or identification information (such as a consumer identifier, an address, etc.) of the site 106-1. In some implementations, the obtained or retrieved utility information may include billed consumption data indicating an amount of utility that was billed over a particular period of time.

In some cases, the acquisition component 214 may obtain or retrieve this utility consumption information from the central office 120 in cases where the acquisition component 214 is unable to obtain the utility consumption information and/or interval data directly from the utility metering device 104-1. For example, the utility metering device 104-1 may be an older model that does not collect such information. Additionally or alternatively, the utility metering device 104-1 may not have a most current software update required to collect and/or transmit such information. Additionally or alternatively, in the case of industrial customers and/or commercial customers, there may not be a specific utility metering device to obtain consumption information and/or interval data because the utility consumption is widespread across a large geographical area (e.g., via traffic lights, street lights, etc.). The acquisition component 214 may obtain or retrieve the utility consumption information from the central office 120 associated with the utility metering device 104-1 associated with the site 106-1 in response to receiving a request from a data engineer associated with the central office 120 or the user 122. Additionally or alternatively, the acquisition component 214 may obtain or retrieve the utility consumption information associated with the site 106-1 from an associated utility service provider. The utility service provider may provide utility consumption information associated with a plurality of sites 106 through its server (e.g., the servers 108 or the central office 120) or website (which may be hosted in the server 108, for example). The utility consumption information system 102 (or the acquisition component 214) may be allowed to download the utility consumption information associated with the site at issue (i.e., the site 106-1 in this example) from the server 108 or a website of the utility service provider after the utility service provider receives and verifies authentication or identification information sent from the utility consumption information system 102. In one implementation, the authentication or identification information may include, for example, a username and a password set up for that site, a pass code or encryption/decryption key set up between the utility consumption information system 102 and the server 108 or the website of the utility service provider, etc.

At block 510, the process 500 may include determining whether or not the utility meter is associated with the customer class. For example, in some cases, the load profile may be applied based at least in part on the utility metering device being associated with a particular customer class. For instance, the estimation component 220 may determine that the utility metering device 104-1 is associated with a residential customer and may determine to apply a load profile to the billed consumption data that is also associated with residential customers (e.g., a load profile generated based on sample data obtained from a sample device (e.g., utility metering device 104-2) also in the residential customer class).

If it is determined that the utility meter is associated with the customer class, the process proceeds to step "A" and subsequently to block 512. If not, the process proceeds to block 520. At block 512, the process 500 may include determining whether the second weather data associated with the utility meter corresponds to the first weather data. If yes, the process 500 proceeds to block 514. If no, the process proceeds to block 522. For example, the load profile may be applied to the billed consumption data based at least in part on weather data associated with the utility metering device 104-1 during the period in time in which the utility was billed. For example, each load profile may be associated with particular weather data experienced by the sample device from which the load profile was generated. The estimation component 220 may apply load profiles to billed consumption data based on a similarity between the weather data associated with the utility metering device 104-1 during the period in time in which the utility was billed and the weather data associated with each load profile.

At block 514, the process 500 may include applying the load profile to the billed consumption data based at least in part on the utility meter being associated with the customer class and the second weather data associated with the utility meter corresponding to the first weather data. For example, an estimation component 220 may be used to apply one or more load profiles to received billed consumption data in order to estimate interval data associated with the billed consumption data. For example, the estimation component 220 may receive billed consumption data (e.g., via the acquisition component 214) for a utility metering device and apply a load profile to the billed consumption data. In some cases, the load profile may be applied based at least in part on the utility metering device being associated with a particular customer class. For instance, the estimation component 220 may determine that the utility metering device 104-1 is associated with a residential customer and may determine to apply a load profile to the billed consumption data that is also associated with residential customers (e.g., a load profile generated based on sample data obtained from a sample device (e.g., utility metering device 104-2) also in the residential customer class). In some cases, the load profile may be applied to the billed consumption data based at least in part on weather data associated with the utility metering device 104-1 during the period in time in which the utility was billed. For example, each load profile may be associated with particular weather data experienced by the sample device from which the load profile was generated. The estimation component 220 may apply load profiles to billed consumption data based on a similarity between the weather data associated with the utility metering device 104-1 during the period in time in which the utility was billed and the weather data associated with each load profile. In some cases, the load profile may be applied to the billed consumption data based at least in part on the utility metering device 104-1 being within a geographical distance to a particular sample device (e.g., utility metering device 104-2). For instance, the utility consumption information system may receive sample data (e.g., interval data) from multiple sample devices each of which is located in a geographical area. Other utility metering devices may be located within those geographical areas (e.g., within a 5-mile radius) and the estimation component 220 may determine to apply a load profile to billed consumption data based on the load profile generated for the sample device located in the same geographical area as the utility metering device.

At block 516, the process 500 may include generating interval data associated with the bill consumption data based at least in part on applying the load profile to the billed consumption data. For example, the estimation component 220 may utilize a combination of data to determine which load profile to apply to the billed consumption data and to generate interval data associated with the billed consumption data. For example, the estimation component 220 may utilize customer class data (e.g., residential customer, commercial customer, or industrial customer), weather data, and/or geographic data to determine which load profile to apply to the billed consumption data to generate the interval data. In this way, the estimation component 220 may allocate larger portions of a utility bill to a higher frequency interval, as opposed to the initially received billed consumption data, which only indicates an overall amount of utility used and/or billed for a period of time.

At block 518, the process 500 may include storing the interval data. For example, the utility consumption information system 102 may include a log database 224. The log database 224 may store the utility consumption data of the site 106. The log database 224 may also store data representing one or more billing cycles. The log database 224 may store predefined settings of the utility consumption information system 102 and/or instructions received from the user 122.

At blocks 520 and 522, the process 500 may include refraining from applying the load profile to the billed consumption data.

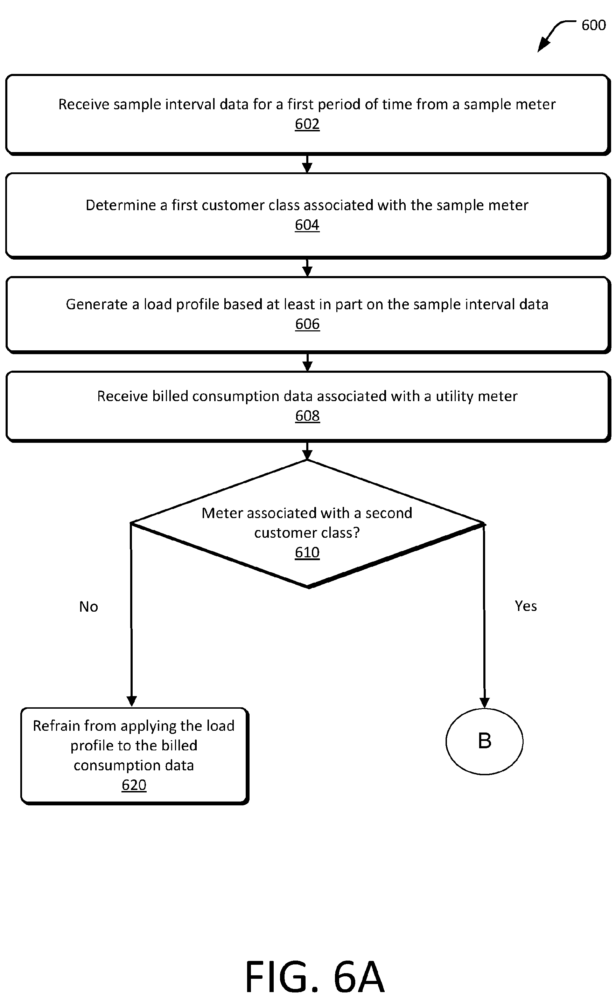

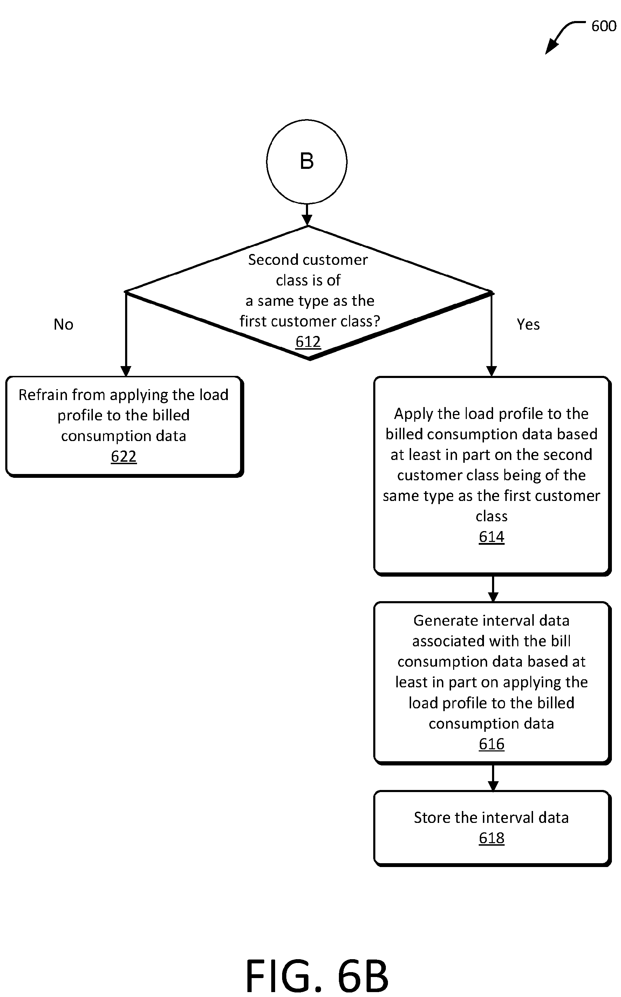

FIGS. 6A and 6B illustrate a flow diagram of an example process 600 for estimating interval data for billed utility consumption data. The order in which the operations or steps are described is not intended to be construed as a limitation, and any number of the described operations may be combined in any order and/or in parallel to implement process 600. The operations described with respect to the process 600 are described as being performed by the utility consumption information system. However, it should be understood that some or all of these operations may be performed by some or all of components, devices, and/or systems described herein.

At block 602, the process 600 may include receiving sample interval data for a first period of time from a sample meter. For example, the acquisition component 214 may receive sample interval data for a period of time from a sample device that is associated with a particular customer class. For example, the sample device may be a utility meter that is in communication with the acquisition component 214 and provides the acquisition component 214 with consumption data readings on an interval basis (e.g., every hour).

At block 604, the process 600 may include determining a first customer class associated with the sample meter. For example, the acquisition component 214 may receive sample data from multiple meters (e.g., 200, 300, 400, etc.) representative of different customer classes and/or different geographical regions experiencing different types of weather.

At block 606, the process 600 may include generating a load profile based at least in part on the sample interval data and the weather data. For example, the load profile component 216 may generate a load profile associated with a sample meter (e.g., utility metering device 104-2) and the period of time in which the sample data was obtained. For example, the load profile may indicate a shape formed by the sample data (also referred to as interval data) obtained from the sample device that is determined by one or more statistical models that relate one or more factors, such as weather data, time data (e.g., day or night, weekends, holidays, etc.), and/or customer classification. The shape of the load profile may enable the load profile component 216 to allocate larger portions of a utility bill to a higher frequency interval and smaller portions of a utility bill to a lower frequency interval.

At block 608, the process 600 may include receiving billed consumption data associated with a utility meter. For example, the acquisition component 214 may, in some cases, obtain utility information associated with the site 106-1 from the utility metering device 104-1. The obtained or retrieved utility information may include raw data (such as consumption usage reading of a utility service) measured and/or output by the utility metering device 104-1 for the site 106-1. In some implementations, the obtained or retrieved utility information may include identification information (such as a device identifier) of the utility metering device 104-1 and/or identification information (such as a consumer identifier, an address, etc.) of the site 106-1. In some implementations, the obtained or retrieved utility information may include billed consumption data indicating an amount of utility that was billed over a particular period of time.

In some cases, the acquisition component 214 may obtain or retrieve this utility consumption information from the central office 120 in cases where the acquisition component 214 is unable to obtain the utility consumption information and/or interval data directly from the utility metering device 104-1. For example, the utility metering device 104-1 may be an older model that does not collect such information. Additionally or alternatively, the utility metering device 104-1 may not have a most current software update required to collect and/or transmit such information. Additionally or alternatively, in the case of industrial customers and/or commercial customers, there may not be a specific utility metering device to obtain consumption information and/or interval data because the utility consumption is widespread across a large geographical area (e.g., via traffic lights, street lights, etc.). The acquisition component 214 may obtain or retrieve the utility consumption information from the central office 120 associated with the utility metering device 104-1 associated with the site 106-1 in response to receiving a request from a data engineer associated with the central office 120 or the user 122. Additionally or alternatively, the acquisition component 214 may obtain or retrieve the utility consumption information associated with the site 106-1 from an associated utility service provider. The utility service provider may provide utility consumption information associated with a plurality of sites 106 through its server (e.g., the servers 108 or the central office 120) or website (which may be hosted in the server 108, for example). The utility consumption information system 102 (or the acquisition component 214) may be allowed to download the utility consumption information associated with the site at issue (i.e., the site 106-1 in this example) from the server 108 or a website of the utility service provider after the utility service provider receives and verifies authentication or identification information sent from the utility consumption information system 102. In one implementation, the authentication or identification information may include, for example, a username and a password set up for that site, a pass code or encryption/decryption key set up between the utility consumption information system 102 and the server 108 or the website of the utility service provider, etc.

At block 610, the process 600 may include determining whether or not the utility meter is associated with the customer class. For example, in some cases, the load profile may be applied based at least in part on the utility metering device being associated with a particular customer class. For instance, the estimation component 220 may determine that the utility metering device 104-1 is associated with a residential customer and may determine to apply a load profile to the billed consumption data that is also associated with residential customers (e.g., a load profile generated based on sample data obtained from a sample device (e.g., utility metering device 104-2) also in the residential customer class).

If it is determined that the utility meter is associated with the second customer class, the process proceeds to step "B" and subsequently to block 612. If not, the process proceeds to block 620. At block 612, the process 600 may include whether the second customer class is of a same type as the first customer class. If yes, the process 600 proceeds to block 614. If no, the process proceeds to block 622. For example, the utility consumption information system may determine which load profile to apply to billed consumption data of the site for a given period of time based on the site being in the same customer class (e.g., residential customer, commercial customer, or industrial customer) as the site in which the sample interval data was obtained.

At block 614, the process 600 may include applying the load profile to the billed consumption data based at least in part on the second customer class being of the same type as the first customer class. For example, an estimation component 220 may be used to apply one or more load profiles to received billed consumption data in order to estimate interval data associated with the billed consumption data. For example, the estimation component 220 may receive billed consumption data (e.g., via the acquisition component 214) for a utility metering device and apply a load profile to the billed consumption data. In some cases, the load profile may be applied based at least in part on the utility metering device being associated with a particular customer class. For instance, the estimation component 220 may determine that the utility metering device 104-1 is associated with a residential customer and may determine to apply a load profile to the billed consumption data that is also associated with residential customers (e.g., a load profile generated based on sample data obtained from a sample device (e.g., utility metering device 104-2) also in the residential customer class). In some cases, the load profile may be applied to the billed consumption data based at least in part on weather data associated with the utility metering device 104-1 during the period in time in which the utility was billed. For example, each load profile may be associated with particular weather data experienced by the sample device from which the load profile was generated. The estimation component 220 may apply load profiles to billed consumption data based on a similarity between the weather data associated with the utility metering device 104-1 during the period in time in which the utility was billed and the weather data associated with each load profile. In some cases, the load profile may be applied to the billed consumption data based at least in part on the utility metering device 104-1 being within a geographical distance to a particular sample device (e.g., utility metering device 104-2). For instance, the utility consumption information system may receive sample data (e.g., interval data) from multiple sample devices each of which is located in a geographical area. Other utility metering devices may be located within those geographical areas (e.g., within a 5-mile radius) and the estimation component 220 may determine to apply a load profile to billed consumption data based on the load profile generated for the sample device located in the same geographical area as the utility metering device.

At block 616, the process 600 may include generating interval data associated with the bill consumption data based at least in part on applying the load profile to the billed consumption data. For example, the estimation component 220 may utilize a combination of data to determine which load profile to apply to the billed consumption data and to generate interval data associated with the billed consumption data. For example, the estimation component 220 may utilize customer class data (e.g., residential customer, commercial customer, or industrial customer), weather data, and/or geographic data to determine which load profile to apply to the billed consumption data to generate the interval data. In this way, the estimation component 220 may allocate larger portions of a utility bill to a higher frequency interval, as opposed to the initially received billed consumption data, which only indicates an overall amount of utility used and/or billed for a period of time.

At block 618, the process 600 may include storing the interval data. For example, the utility consumption information system 102 may include a log database 224. The log database 224 may store the utility consumption data of the site 106. The log database 224 may also store data representing one or more billing cycles. The log database 224 may store predefined settings of the utility consumption information system 102 and/or instructions received from the user 122.

At blocks 620 and 622, the process 600 may include refraining from applying the load profile to the billed consumption data.

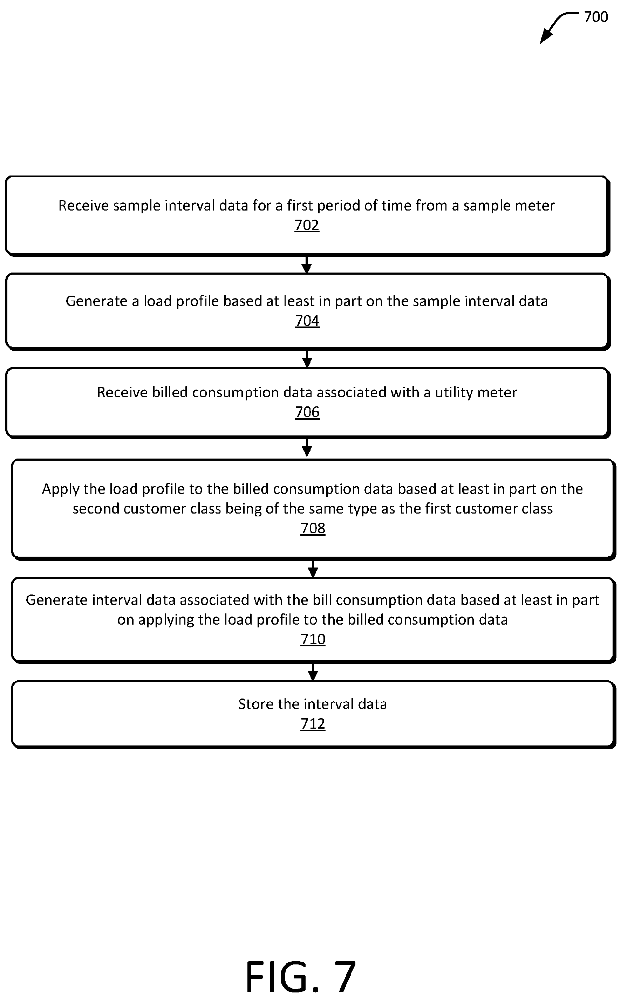

FIG. 7 illustrates a flow diagram of an example process 700 for estimating interval data for billed utility consumption data. The order in which the operations or steps are described is not intended to be construed as a limitation, and any number of the described operations may be combined in any order and/or in parallel to implement process 700. The operations described with respect to the process 700 are described as being performed by the utility consumption information system. However, it should be understood that some or all of these operations may be performed by some or all of components, devices, and/or systems described herein.

At block 702, the process 700 may include receiving sample interval data for a first period of time from a sample meter. For example, the acquisition component 214 may receive sample interval data for a period of time from a sample device that is associated with a particular customer class. For example, the sample device may be a utility meter that is in communication with the acquisition component 214 and provides the acquisition component 214 with consumption data readings on an interval basis (e.g., every hour).

At block 704, the process 700 may include generating a load profile based at least in part on the sample interval. For example, the load profile component 216 may generate a load profile associated with a sample meter (e.g., utility metering device 104-2) and the period of time in which the sample data was obtained. For example, the load profile may indicate a shape formed by the sample data (also referred to as interval data) obtained from the sample device that is determined by one or more statistical models that relate one or more factors, such as weather data, time data (e.g., day or night, weekends, holidays, etc.), and/or customer classification. The shape of the load profile may enable the load profile component 216 to allocate larger portions of a utility bill to a higher frequency interval and smaller portions of a utility bill to a lower frequency interval.

At block 706, the process 700 may include receiving billed consumption data associated with a utility meter. For example, the acquisition component 214 may, in some cases, obtain utility information associated with the site 106-1 from the utility metering device 104-1. The obtained or retrieved utility information may include raw data (such as consumption usage reading of a utility service) measured and/or output by the utility metering device 104-1 for the site 106-1. In some implementations, the obtained or retrieved utility information may include identification information (such as a device identifier) of the utility metering device 104-1 and/or identification information (such as a consumer identifier, an address, etc.) of the site 106-1. In some implementations, the obtained or retrieved utility information may include billed consumption data indicating an amount of utility that was billed over a particular period of time.

In some cases, the acquisition component 214 may obtain or retrieve this utility consumption information from the central office 120 in cases where the acquisition component 214 is unable to obtain the utility consumption information and/or interval data directly from the utility metering device 104-1. For example, the utility metering device 104-1 may be an older model that does not collect such information. Additionally or alternatively, the utility metering device 104-1 may not have a most current software update required to collect and/or transmit such information. Additionally or alternatively, in the case of industrial customers and/or commercial customers, there may not be a specific utility metering device to obtain consumption information and/or interval data because the utility consumption is widespread across a large geographical area (e.g., via traffic lights, street lights, etc.). The acquisition component 214 may obtain or retrieve the utility consumption information from the central office 120 associated with the utility metering device 104-1 associated with the site 106-1 in response to receiving a request from a data engineer associated with the central office 120 or the user 122. Additionally or alternatively, the acquisition component 214 may obtain or retrieve the utility consumption information associated with the site 106-1 from an associated utility service provider. The utility service provider may provide utility consumption information associated with a plurality of sites 106 through its server (e.g., the servers 108 or the central office 120) or website (which may be hosted in the server 108, for example). The utility consumption information system 102 (or the acquisition component 214) may be allowed to download the utility consumption information associated with the site at issue (i.e., the site 106-1 in this example) from the server 108 or a website of the utility service provider after the utility service provider receives and verifies authentication or identification information sent from the utility consumption information system 102. In one implementation, the authentication or identification information may include, for example, a username and a password set up for that site, a pass code or encryption/decryption key set up between the utility consumption information system 102 and the server 108 or the website of the utility service provider, etc.

At block 708, the process 700 may include applying the load profile to the billed consumption data. For example, an estimation component 220 may be used to apply one or more load profiles to received billed consumption data in order to estimate interval data associated with the billed consumption data. For example, the estimation component 220 may receive billed consumption data (e.g., via the acquisition component 214) for a utility metering device and apply a load profile to the billed consumption data. In some cases, the load profile may be applied based at least in part on the utility metering device being associated with a particular customer class. For instance, the estimation component 220 may determine that the utility metering device 104-1 is associated with a residential customer and may determine to apply a load profile to the billed consumption data that is also associated with residential customers (e.g., a load profile generated based on sample data obtained from a sample device (e.g., utility metering device 104-2) also in the residential customer class). In some cases, the load profile may be applied to the billed consumption data based at least in part on weather data associated with the utility metering device 104-1 during the period in time in which the utility was billed. For example, each load profile may be associated with particular weather data experienced by the sample device from which the load profile was generated. The estimation component 220 may apply load profiles to billed consumption data based on a similarity between the weather data associated with the utility metering device 104-1 during the period in time in which the utility was billed and the weather data associated with each load profile. In some cases, the load profile may be applied to the billed consumption data based at least in part on the utility metering device 104-1 being within a geographical distance to a particular sample device (e.g., utility metering device 104-2). For instance, the utility consumption information system may receive sample data (e.g., interval data) from multiple sample devices each of which is located in a geographical area. Other utility metering devices may be located within those geographical areas (e.g., within a 5-mile radius) and the estimation component 220 may determine to apply a load profile to billed consumption data based on the load profile generated for the sample device located in the same geographical area as the utility metering device.

At block 710, the process 700 may include generating interval data associated with the bill consumption data based at least in part on applying the load profile to the billed consumption data. For example, the estimation component 220 may utilize a combination of data to determine which load profile to apply to the billed consumption data and to generate interval data associated with the billed consumption data. For example, the estimation component 220 may utilize customer class data (e.g., residential customer, commercial customer, or industrial customer), weather data, and/or geographic data to determine which load profile to apply to the billed consumption data to generate the interval data. In this way, the estimation component 220 may allocate larger portions of a utility bill to a higher frequency interval, as opposed to the initially received billed consumption data, which only indicates an overall amount of utility used and/or billed for a period of time.

At block 712, the process 700 may include storing the interval data. For example, the utility consumption information system 102 may include a log database 224. The log database 224 may store the utility consumption data of the site 106. The log database 224 may also store data representing one or more billing cycles. The log database 224 may store predefined settings of the utility consumption information system 102 and/or instructions received from the user 122.

Any of the acts of any of the methods described herein may be implemented at least partially by a processor or other electronic device based on instructions stored on one or more computer-readable media. By way of example and not limitation, any of the acts of any of the methods described herein may be implemented under control of one or more processors configured with executable instructions that may be stored on one or more computer-readable media such as one or more computer storage media.

The disclosure also comprises the following numbered clauses:
1. A method comprising:
   receiving sample interval data for a first period of time from a sample meter;
   generating a load profile based at least in part on the sample interval data;
   receiving billed consumption data associated with a site;
   applying the load profile to the billed consumption data;
   generating interval data associated with the billed consumption data based at least in part on applying the load profile to the billed consumption data; and
   storing the interval data.
2. The method of clause 1, wherein applying the load profile to the billed consumption data is based at least in part on determining that first weather data associated with the site corresponds to second weather data associated with the sample meter.
3. The method of any preceding clause, further comprising validating the billed consumption data prior to applying the load profile to the billed consumption data, wherein the validating includes a maximum threshold value and a minimum threshold value.
4. The method of any preceding clause, further comprising:
   determining a first register value associated with the billed consumption data;
   determining a second register value associated with the billed consumption data; and
   generating a register read value associated with the billed consumption data based at least in part on a difference between the first register value and the second register value, wherein applying the load profile to the billed consumption data comprises applying the load profile to the register read value.
5. The method of clause 4, further comprising:
   generating an interval container having a number of intervals; and
   storing the register read value in the interval container such that the register read value is distributed amongst the number of intervals.
6. The method of any preceding clause wherein applying the load profile to the billed consumption data is based at least in part on a customer class associated with the site.
7. One or more computer-readable media storing computer-executable instructions that, when executed by one or more processors, cause a computing device to carry out the method of any preceding clause.

### Conclusion

Although the invention has been described in language specific to structural features and/or methodological acts, it is to be understood that the invention is not necessarily limited to the specific features or acts described. Rather, the specific features and acts are disclosed as exemplary forms of implementing the invention.

## Claims

1. A method comprising:
receiving sample interval data for a first period of time from a sample meter associated with a customer class;
determining first weather data associated with the first period of time;
generating a load profile based at least in part on the sample interval data and the first weather data;
receiving billed consumption data associated with a utility meter;
determining that the utility meter is associated with the customer class;
determining that second weather data associated with the utility meter corresponds to the first weather data;
applying the load profile to the billed consumption data based at least in part on the utility meter being associated with the customer class and the second weather data associated with the utility meter corresponding to the first weather data;
generating interval data associated with the billed consumption data based at least in part on applying the load profile to the billed consumption data; and
storing the interval data.

2. The method of claim 1, wherein determining that second weather data associated with the utility meter corresponds to the first weather data is based on the utility meter being in a service territory associated with the sample meter.

3. The method of claim 1 or 2, further comprising validating the billed consumption data prior to applying the load profile to the billed consumption data, wherein the validating includes a maximum threshold value and a minimum threshold value.

4. The method of any preceding claim, further comprising:
determining a first register value associated with the billed consumption data;
determining a second register value associated with the billed consumption data; and
generating a register read value associated with the billed consumption data based at least in part on a difference between the first register value and the second register value, wherein applying the load profile to the billed consumption data comprises applying the load profile to the register read value.

5. The method of claim 4, further comprising:
generating an interval container having a number of intervals; and
storing the register read value in the interval container such that the register read value is distributed amongst the number of intervals.

6. The method of any preceding claim, wherein the customer class comprises at least one of a residential customer, a commercial customer, or an industrial customer.

7. The method of any preceding claim, wherein generating the load profile comprises utilizing one or more statistical models.

8. One or more computer-readable media storing computer-executable instructions that, when executed by one or more processors, cause a computing device to carry out the method of any preceding claim.

9. A system comprising:
one or more processors;
a memory; and
instructions stored in the memory that, when executed by the one or more processors, cause the one or more processors to perform operations comprising:
receiving sample interval data for a first period of time from a sample meter;
determining a first customer class associated with the sample meter;
generating a load profile based at least in part on the sample interval data;
receiving billed consumption data associated with a utility meter;
determining that the utility meter is associated with a second customer class;
determining that the second customer class is of a same type as the first customer class;
applying the load profile to the billed consumption data based at least in part on the second customer class being of the same type as the first customer class;
generating interval data associated with the billed consumption data based at least in part on applying the load profile to the billed consumption data; and
storing the interval data.

10. The system of claim 9, wherein applying the load profile to the billed consumption data is based at least in part on determining that first weather data associated with the utility meter corresponds to second weather data associated with the sample meter.

11. The system of claim 9 or 10, the operations further comprising validating the billed consumption data prior to applying the load profile to the billed consumption data, wherein the validating includes a maximum threshold value and a minimum threshold value.

12. The system of any of claims 9 to 11, the operations further comprising:
determining a first register value associated with the billed consumption data;
determining a second register value associated with the billed consumption data; and
generating a register read value associated with the billed consumption data based at least in part on a difference between the first register value and the second register value, wherein applying the load profile to the billed consumption data comprises applying the load profile to the register read value.

13. The system of claim 12, the operations further comprising:
generating an interval container having a number of intervals; and
storing the register read value in the interval container such that the register read value is distributed amongst the number of intervals.

14. The system of any of claims 9 to 13, wherein at least one of the first customer class or the second customer class comprises at least one of a residential customer, a commercial customer, or an industrial customer.

15. The system of any of claims 9 to 14, wherein generating the load profile comprises utilizing one or more statistical models.
